# EUROPEAN PATENT APPLICATION

(11) **EP 2 337 198 A2**
(43) Date of publication of application: **22.06.2011**
(21) Application number: 10174157.7
(22) Date of filing: 26.08.2010
(51) Int. Cl.: H02M 1/12

(54) **Noise suppression device and air conditioner**

(30) Priority: 09.11.2009 JP 2009255997
(71) Applicant: Mitsubishi Electric Corporation, Chiyoda-ku Tokyo 100-8310 (JP)
(72) Inventor: Makino, Yasushi, Tokyo 100-8310 (JP); Momose, Ryuji, Tokyo 100-8310 (JP); Itoi, Yuuichi, Tokyo 100-8310 (JP); Iwata, Yukihiko, Tokyo 100-8310 (JP)
(74) Representative: Ilgart, Jean-Christophe

(57) **Abstract**

The invention concerns a noise suppression device comprising :
a magnetic body (23) formed in a ring shape forming a hollow part therein;
a power signal line (7a, 7b) wound around the magnetic body through the hollow part; and
a ground line (15) passing through the hollow part.

## Description

### BACKGROUND OF THE INVENTION

### Field of the Invention

The present invention relates to a noise suppression device for suppressing noise currents generated by an electrical appliance having an inverter device. Particularly, the present invention is suitable for a noise suppression device to be implemented in an outdoor unit of an air conditioner having an inverter device.

### Description of the Related Art

In a conventional outdoor unit of an air conditioner, a noise filter is used for preventing a noise generated by an inverter device of the outdoor unit from being discharged from the inverter device toward an external power supply, the noise filter being comprised of a common mode coil formed by winding a power line and a common-mode current free-wheeling line, respectively, in the same direction with the same number of turns, and a line bypass capacitor between the power supply line and the ground (as disclosed, for example, in JP2001-268890).

Since an excessive discharge of noise current toward an external power supply may cause malfunction in other electrical equipment, the discharge of noise components is regulated by laws and regulations in various countries. For example, products destined for Japan must comply with the Electrical Appliance and Material Safety Act, and products destined for European markets must comply with the EMC Directive (EN55014-1).

In a conventional noise suppression device comprised of a common mode coil as described above, it is necessary to increase the number of turns on the common mode coil or to increase the size of the common mode coil to obtain a sufficient amount of inductance required for noise suppression as the level of generated noise increases. This inevitably leads to increased coil mounting space and to increased manufacturing costs such as material costs.

### SUMMARY OF THE INVENTION

The present invention was made to solve the above-mentioned problems.

It is a first object of the present invention to provide a noise suppression device with a high efficacy for suppressing the discharge, toward an external power supply, of noise currents generated by driving of an inverter device.

It is a second object of the present invention to provide a lower-cost air conditioner with an inverter by reducing the size of a noise suppression device.

According to a first aspect of the present invention, a noise suppression device is comprised of a magnetic body formed in a ring shape forming a hollow part therein, a power signal line wound around the magnetic body through the hollow part, and a ground line passing through the hollow part.

According to a second aspect of the present invention, a noise suppression device is comprised of a magnetic body formed in a ring shape forming a hollow part therein, a power signal line wound around the magnetic body through the hollow part, and a ground line wound around the magnetic body through the hollow part.

According to a third aspect of the present invention, a connection terminal is provided at least at one end of an end of the power signal line and an end of the ground line.

According to a fourth aspect of the present invention, a noise suppression device is comprised of a magnetic body formed in a ring shape forming a hollow part therein, a power signal line wound around the magnetic body through the hollow part, and a ground line passing through the hollow part, wherein one end of the power signal line is connected to an external power supply, another end of the power signal line is connected to an internal circuit, one end of the ground line is connected to a ground of the internal circuit, and another end of the ground line is connected to an external ground, and wherein a direction of a first magnetic flux generated at the magnetic body by a first noise current flowing through the power signal line and a direction of a second magnetic flux generated at the magnetic body by a second noise current flowing through the ground line are opposite to each other.

According to a fifth aspect of the present invention, the magnetic body is made of ferrite.

According to a sixth aspect of the present invention, an air conditioner comprising the above-described noise suppression device is provided.

The invention concerns a noise suppression device, characterized in that it comprises :
a magnetic body formed in a ring shape forming a hollow part therein;
a power signal line wound around the magnetic body through the hollow part; and
a ground line passing through the hollow part.

The invention also concerns a noise suppression device, characterized in that it comprises :
a magnetic body formed in a ring shape forming a hollow part therein;
a power signal line wound around the magnetic body through the hollow part; and
a ground line wound around the magnetic body through the hollow part.

Advantageously a connection terminal is provided at least at one end of an end of the power signal line and an end of the ground line.

The invention also concerns a noise suppression device, characterized in that it comprises :
a magnetic body formed in a ring shape forming a hollow part therein;
a power signal line wound around the magnetic body through the hollow part; and
a ground line passing through the hollow part,
   in that one end of the power signal line is connected to an external power supply, another end of the power signal line is connected to an internal circuit, one end of the ground line is connected to a ground of the internal circuit, and another end of the ground line is connected to an external ground, and
   in that a direction of a first magnetic flux generated at the magnetic body by a first noise current flowing through the power signal line and a direction of a second magnetic flux generated at the magnetic body by a second noise current flowing through the ground line are opposite to each other.

Advantageously the magnetic body is made of ferrite.

The invention concerns an air conditioner comprising a noise suppression device as described above.

### BRIEF DESCRIPTION OF THE DRAWINGS

Fig. 1 shows a configuration of an air conditioner comprising a noise suppression device according to the first embodiment of the present invention.
Fig. 2 shows a configuration of a noise suppression device according to the first embodiment of the present invention.
Fig. 3 shows a configuration of a second noise suppression unit according to the first embodiment of the present invention.
Fig. 4 shows a configuration of a second noise suppression unit according to the second embodiment of the present invention.

### DETAILED DESCRIPTION OF THE PREFERRED EMBODIMENTS

### Embodiment 1

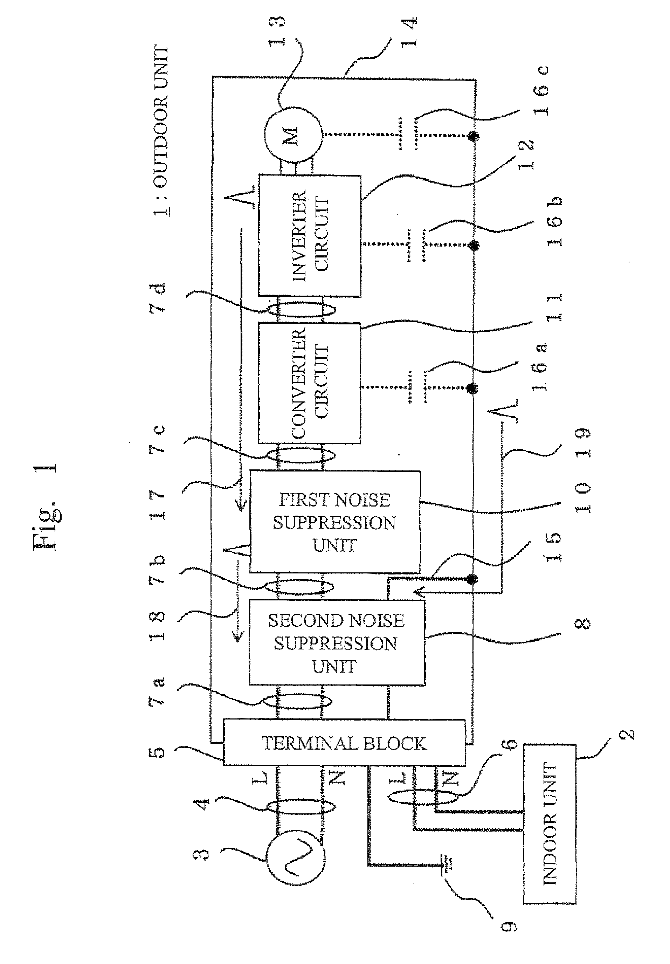

A noise suppression device according to the first embodiment will be explained with reference to the accompanying drawings. Fig. 1 shows a configuration of an air conditioner having a noise suppression device according to the first embodiment. The air conditioner is comprised of an outdoor unit 1 and an indoor unit 2, and is powered from an external power supply 3 through power signal lines 4. The power signal lines 4 from the external power supply 3 are connected to a terminal block 5 provided in the outdoor unit 1, and a pair of power signal lines 6 that is branched at the terminal block 5 is connected to the indoor unit 2 to supply power thereto. Another pair of power signal lines 7a that is branched at the terminal block 5 is connected to a second noise suppression unit 8. Further, a ground 9 is connected to the terminal block 5.

Power received at the terminal block 5 is sequentially supplied to the second noise suppression unit 8, the first noise suppression unit 10, a converter circuit 11, and an inverter circuit 12 through power signal lines 7a, 7b, 7c, and 7d. The signal lines such as the power signal lines 7a may be fixedly connected to the circuits such as the second noise suppression unit 8 by such means as soldering. The first noise suppression unit 10 and the second noise suppression unit 8 comprise a noise suppression device, the noise suppression device having a function of suppressing noise components superimposed on the power signals. A configuration of the noise suppression device will be described in detail later. The converter circuit 11, comprised of such elements as an active filter (not shown herein), converts the power signals from alternating current to direct current and vice versa. The converted power signals are supplied to the inverter circuit 12, and the inverter circuit 12 drives a compressor 13 by means of inverter control. The inverter circuit 12 may be implemented with a commercially available intelligent power module (IPM).

The outdoor unit 1 is cased in a housing 14 (for example, a metal sheet), the housing 14 being connected with the terminal block 5 by a ground line 15 and thus having the same electric potential as the ground 9. The ground line 15 is connected to the terminal block 5 through the second noise suppression unit 8, a detailed configuration thereof will be described later. Further, the converter circuit 11, the inverter circuit 12, and the compressor 13 are cased in the housing 14, as a result of which stray capacitances 16a, 16b, and 16c exist between these circuits or the device and the housing 14.

When the converter circuit 11 and the inverter circuit 12 are activated and the compressor 13 is put into operation, a noise current (noise component) 17 is generated. The noise current 17 reaches the first noise suppression unit 10 through the inverter circuit 12 and the converter circuit 11.

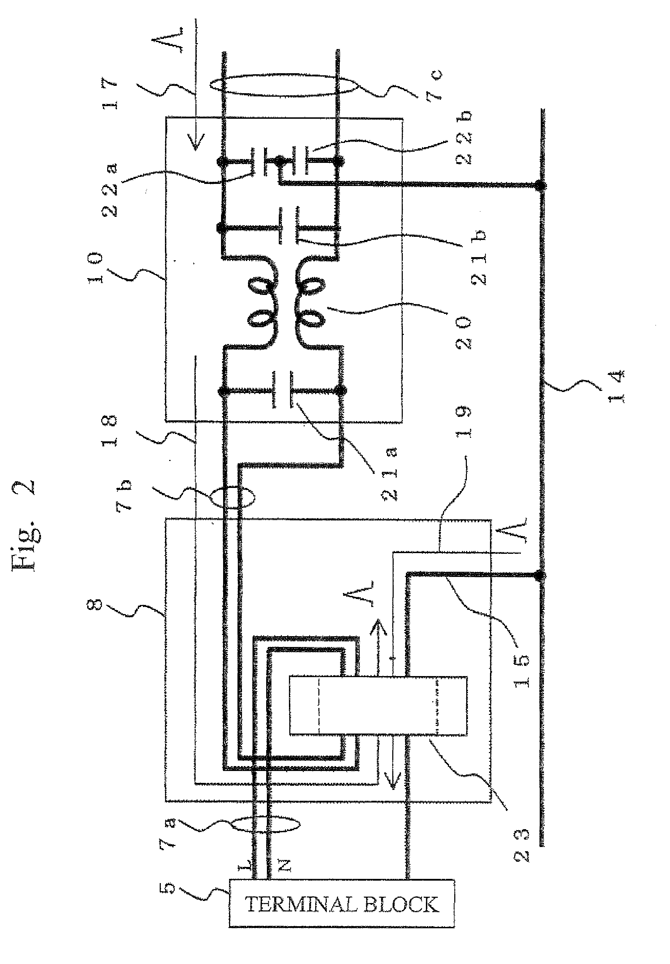

Fig. 2 shows a configuration of a noise suppression device comprising the first noise suppression unit 10 and the second noise suppression unit 8, together with the terminal block 5 and the housing 14. In Fig. 2, the elements that appear in Fig. 1 are identified with the same reference numerals as those used in Fig. 1. The first noise suppression unit 10 is comprised of a common mode choke coil 20, capacitors (X capacitors) 21a and 21b, and capacitors (Y capacitors) 22a and 22b, the first noise suppression unit 10 having a function of suppressing the noise current 17 which is a common mode noise. It is to be understood that the configuration of the first noise suppression unit 10 is not limited to that described herein and that a general-purpose noise filter may also be used.

The first noise suppression unit 10 is configured in such a way as to allow it to be mounted on a circuit board with other parts. In this case, since the physical configuration of the first noise suppression unit 10 is subject to a limitation imposed by the size of the board, the noise suppression capability of the first noise suppression unit 10 is also inevitably limited. When the level of a noise or a bandwidth component is so high as to exceed the noise suppression capability of the noise suppression unit 10, the noise current that cannot be suppressed in the first noise suppression unit 10 is discharged toward the external power supply as a noise current 18. Further, a noise current 19 flows into the ground line 15 from the compressor 13, the inverter circuit 12, and the converter circuit 11, through the stray capacitances 16a, 16b, and 16c and the housing 14.

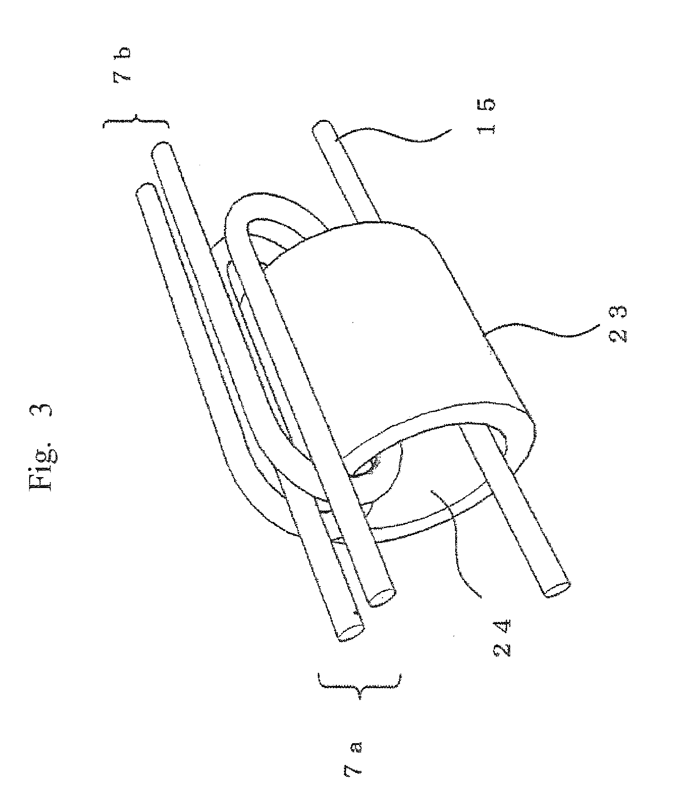

Fig. 3 shows a perspective view of the second noise suppression unit 8. The second noise suppression unit 8 is comprised of a magnetic body (such as a ferrite core) 23, being formed in a ring shape forming a hollow part 24 therein and made of a single body. The second noise suppression unit 8 is configured so that the power signal lines 7b from the first noise suppression unit 10 are wound around the magnetic body 23, from outside of the magnetic body 23 through the hollow part 24, to come out from the magnetic body 23 as the signal lines 7a, and that the ground line 15 passes through the hollow part 24 of the magnetic body 23. A magnetic flux generated at the magnetic body 23 by the noise current 18 and a magnetic flux generated at the magnetic body 23 by the noise current 19 cancel out each other, because these noise currents flow through the hollow part 24 of the magnetic body 23 in mutually opposite directions. This mutual cancellation of the noise current 18 and the noise current 19 greatly reduces noise propagation toward the external power supply.

Further, the second noise suppression unit 8 is configured in such a way so that a magnetic flux generated at the magnetic body 23 by the power signal lines 7a and 7b and a magnetic flux generated at the magnetic body 23 by the ground line 15 flow in mutually opposite directions, allowing the noise currents, even if increased depending on the magnitude of supply current, to cancel out each other. In this way, the noise components can be effectively suppressed. This allows the second noise suppression unit 8 to be configured with a small magnetic core, even in the case of high noise currents, contributing to overall size reduction of the noise suppression device.

Further, by mounting the first noise suppression unit 10 on a circuit board, together with the inverter circuit 12, and attaching the second noise suppression unit 8 outside of the board, the magnetic body 23 can be specifically designed according to changes in noise generation conditions, thus allowing a wider variety of noise suppression devices to be easily realized.

In the above description, the second noise suppression unit 8 is configured so that the power signal lines 7b are wound once around the magnetic body 23 through the hollow part 24 thereof and that the ground line 15 passes through the hollow part 24 of the magnetic body 23. However, the configuration is not limited to this. The power signal lines 7b may be wound around the magnetic body 23 multiple times. Also, the ground line 15 may be wound around the magnetic body 23 through the hollow part 24 thereof, as in the case of the power signal lines 7b, instead of passing through the hollow part 24.

Further, in the first embodiment, the first noise suppression unit and the second noise suppression unit are provided in an outdoor unit of an air conditioner, but the present invention is not limited to this. When an inverter circuit is mounted in an indoor unit, a noise suppression unit may also be provided in the indoor unit. The present invention is applicable to various devices driven by an inverter circuit, including various types of pumps, air blowers, dust collectors, heaters, and coolers.

### Embodiment 2

In the noise suppression device according to the first embodiment, the second noise suppression unit 8 is fixedly connected with the terminal block 5 as well as with the first noise suppression unit 10 through the power signal lines 7a and 7b and the ground line 15 by such means as soldering. In this embodiment, a connection terminal is provided at an end of the power signal lines 7a and 7b and the ground line 15 so as to be attachable and detachable to and from the second noise suppression unit 8.

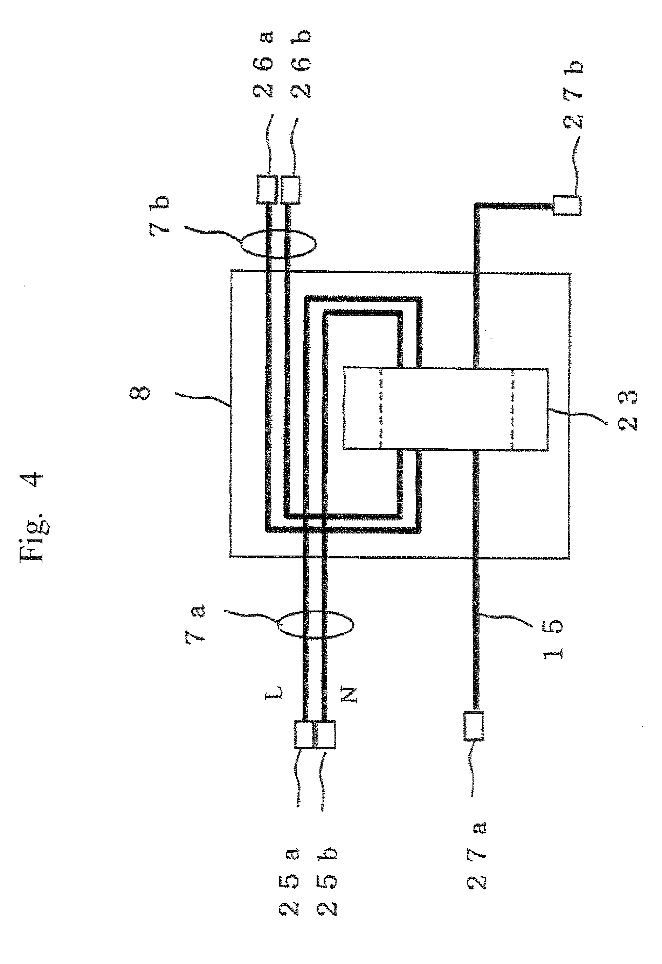

Fig. 4 shows a configuration in which connection terminals 25a, 25b, 26a, and 26b and connection terminals 27a and 27b are provided, respectively, at both ends of the signal lines 7a and 7b and the ground line 15 extending from the second noise suppression unit 8. Further, the terminal block 5 is provided with insertion receptacles for connection terminals so that the connection terminals 25a, 25b, and 27a can be attached and detached. The first noise suppression unit 10 is likewise provided with insertion receptacles for connection terminals so that the connection terminals 26a, 26b, and 27b can be attached and detached.

As described above, according to the second embodiment, the second noise suppression unit 8 is attachable and detachable so as to allow easy replacement of the second noise suppression unit 8. Another advantage is that an assembly procedure of the outdoor unit 1 can be simplified, leading to reduced costs and reduced defects.

A connection terminal may be provided at only one end of the power signal lines and the ground line. This also achieves improved operating efficiency when the second noise suppression unit 8 is implemented outside of a circuit board.

In a noise suppression device according to the above embodiments, the direction of a magnetic flux generated by a noise current passing through the ground line and the direction of a magnetic flux generated by a noise current superimposed on the power signal lines are opposite to each other, thus allowing efficient suppression of generated noise, regardless of the magnitude of supply current. Also, since there is no need to increase inductance depending on the magnitude of generated noise, the noise suppression device can be made in a smaller and lower-cost configuration.

## Claims

1. A noise suppression device, **characterized in that** it comprises:
a magnetic body (23) formed in a ring shape forming a hollow part therein;
a power signal line (7a, 7b) wound around the magnetic body through the hollow part; and
a ground line (15) passing through the hollow part.

2. A noise suppression device, **characterized in that** it comprises:
a magnetic body (23) formed in a ring shape forming a hollow part therein;
a power signal line (7a, 7b) wound around the magnetic body through the hollow part; and
a ground line (15) wound around the magnetic body through the hollow part.

3. The noise suppression device according to claim 1 or claim 2,
wherein a connection terminal is provided at least at one end of an end of the power signal line and an end of the ground line.

4. A noise suppression device, **characterized in that** it comprises:
a magnetic body (23) formed in a ring shape forming a hollow part therein;
a power signal line (7a, 7b) wound around the magnetic body through the hollow part; and
a ground line (15) passing through the hollow part,
**in that** one end of the power signal line is connected to an external power supply, another end of the power signal line is connected to an internal circuit, one end of the ground line is connected to a ground of the internal circuit, and another end of the ground line is connected to an external ground, and
**in that** a direction of a first magnetic flux generated at the magnetic body by a first noise current flowing through the power signal line and a direction of a second magnetic flux generated at the magnetic body by a second noise current flowing through the ground line are opposite to each other.

5. The noise suppression device according to any one of claims 1 to 4,
wherein the magnetic body is made of ferrite.

6. An air conditioner comprising the noise suppression device according to any one of claims 1 to 5.
